# EUROPÄISCHE PATENTSCHRIFT

(11) **EP 2 167 270 B1**
(45) Veröffentlichungstag und Bekanntmachung des Hinweises auf die Patenterteilung: **28.03.2012**
(21) Anmeldenummer: 08760456.7
(22) Anmeldetag: 04.06.2008
(51) Int. Cl.: B23K 20/02, B23K 20/227, H01J 37/32, C23C 16/455

(54) **AUS EINER VIELZAHL DIFFUSIONSVERSCHWEISSTER SCHEIBEN BESTEHENDER GASVERTEILER UND EIN VERFAHREN ZUR FERTIGUNG EINES SOLCHEN GASVERTEILERS**
GAS DISTRIBUTOR COMPRISING A PLURALITY OF DIFFUSION-WELDED PANES AND A METHOD FOR THE PRODUCTION OF SUCH A GAS DISTRIBUTOR
DISTRIBUTEUR DE GAZ A PLUSIEURS RONDELLES SOUDÉES PAR DIFFUSION ET PROCÉDÉ DE FABRICATION D'UN TEL DISTRIBUTEUR DE GAZ

(30) Priorität: 06.06.2007 DE 102007026349
(43) Veröffentlichungstag der Anmeldung: 31.03.2010
(73) Patentinhaber: Aixtron SE, 52134 Herzogenrath (DE)
(72) Erfinder: SAYWELL, Victor, Great Barton Bury St. Edmunds Suffolk IP31 2SW (GB); HUMBY, Chris, Hartford Huntingdon Cambridgeshire PE29 1UX (GB); CRAWLEY, Fred, Orwell Royston Hertfordshire SG8 5QN (GB)
(74) Vertreter: Rieder, Hans-Joachim
(86) Internationale Anmeldenummer: PCT/EP2008/056873
(87) Internationale Veröffentlichungsnummer: WO 2008/148773

(56) Entgegenhaltungen:
- US-A1- 2002 005 442
- US-A1- 2002 152 960
- US-A1- 2005 255 241
- US-A1- 2006 021 574
- US-A1- 2006 162 661

## Beschreibung

Die Erfindung betrifft einen Gasverteiler gemäß dem Oberbegriff des Anspruchs 1 sowie ein Verfahren zur Fertigung eines derartigen Gasverteilers gemäß dem Obergriff des Anspruchs 12 (Siehe, z.B., US 2005/0255 241 A1).

Aus den EP 0 687 749 B1, DE 695 04 762 T2, US 5,871,586, US 2006/0021574 A1 sind derartige, auch "showerhead" genannte Gasverteiler bekannt. Sie bestehen aus in Horizontalrichtung übereinander liegenden Platten. Die Platten besitzen einen vertikalen Abstand zueinander, die den Boden und die Decke jeweils einer Kammer bilden. Die Ränder der Kammern werden von ringförmigen Randteilen aus Stahl gebildet. Der nach unten weisende Boden des Gasverteilers besitzt eine Vielzahl von Gasaustrittsöffnungen. Die darüber liegende Kammer ist eine Kühlkammer, die von einem flüssigen Kühlmittel, beispielsweise Wasser durchströmt wird. Oberhalb dieser Kühlkammer befinden sich zwei voneinander gasdicht getrennte Gasvolumina. Jedes der Gasvolumina ist mit einer Vielzahl von bis mehr als 15.000 Röhrchen mit dem Boden des Gasverteilers verbunden. Die Röhrchen münden in den Gasaustrittsöffnungen und kreuzen dabei zumindest die Kühlkammer.

Die Fertigung derartiger Gasverteiler ist aufwändig, da die Röhrchen einzeln in zuvor gefertigte Bohrungen eingelötet werden müssen. Von Nachteil ist ferner, dass verschiedene Materialien verwendet werden, nämlich einerseits die aus Edelstahl bestehenden Wände der Kammern und Röhrchen und andererseits das Lot.

Aus den DE 696 30 484 T2, EP 1381078 A1 und US 6,444,042 B1 sind Gaseinlassverteiler bekannt, die sandwichartig aus einer Vielzahl von Scheiben ausgebildet sind, wobei die einzelnen Scheiben strukturiert sind, damit innerhalb der Scheibenebene eine Gasverteilung stattfinden kann. Hierzu sind kreuz- und querverlaufende Kanäle vorgesehen. Dabei bilden sie blockartige Erhebungen, die eine zentrale Öffnung besitzen, durch welche ein Gas strömen kann und welche von einem anderen Gas umströmt werden können.

Aus der US 2002/0152960 A1 ist ein Gasverteiler bekannt, der ebenfalls sandwichartig aufgebaut ist. Dort besitzt eine untere und eine obere Scheibe jeweils eine von gitterförmig verlaufenden Nuten gebildete Breitseitenaussparung, so dass rechteckige Sockel mit einer zentralen Öffnung bestehen bleiben. Werden diese äußeren Scheiben unter Zwischenlage einer entsprechend gelochten inneren Scheibe aufeinandergelegt, so entstehen Röhrchen, die jeweils eine Kammer durchdringen.

Aus den US 2006/0201428 A1, US 7,168,447 B2, US 6,302,964 B1, US 2002/0005442 A1 und WO2006/040275 A1 sind ebenfalls Gasverteiler bekannt, die aus mehreren übereinander liegenden Scheiben bestehen. Die Breitseitenflächen der Scheiben sind mit Kanälen versehen. Im zusammengebauten Zustand sind diese Kanäle verschlossen.

Einen gattungsgemäßen Gasverteiler beschreibt die US 2005/0255241 A1. Der dort beschriebene Gasverteiler besitzt mehrere übereinander angeordnete Kammern. Diese werden von drei aufeinanderliegenden und fest miteinander verbundenen Elementen gebildet. Ein mittleres Element bildet Röhrchen und zwischen den Röhrchen angeordnete Kammern. Mit einem unteren Element werden die Kammern verschlossen. Ein oberes Element verschließt eine obere Kammer, die sich zwischen dem mittleren Element und dem oberen Element befindet. Die obere Kammer ist über die besagten Röhrchen mit dem unteren Element, das eine Gasaustrittsfläche ausbildet, verbunden.

Der Erfindung liegt die Aufgabe zugrunde, einen vereinfacht zu fertigenden und technisch verbesserten Gasverteiler anzugeben.

Gelöst wird die Aufgabe durch die in den Ansprüchen 1 und 12 angegebene Erfindung. Die Unteransprüche stellen vorteilhafte Weiterbildungen dar.
Zunächst ist vorgesehen, dass der Gasverteiler aus einer Vielzahl strukturierter, aufeinander liegender Scheiben aus Metall besteht, die miteinander verbunden sind und insbesondere durch Druck und Temperatur miteinander diffusionsverschweißt sind. Insbesondere die Röhrchen können von einer Mehrheit dieser Scheiben ausgebildet werden. Die Röhrchen werden dann aus einer Vielzahl übereinander liegenden Ringscheiben gebildet, wobei die Ringscheiben im Wesentlichen deckungsgleich übereinander liegen. Die Röhrchen werden von diesen Ringscheiben aufgebaut. Die Scheiben bestehen bevorzugt aus Edelstahl und weisen, gemäß der Erfindung, im Bereich der von ihnen ausgebildeten Freiräume bzw. Durchbrechungen die besagten Ringscheiben aus, die über Stege miteinander verbunden sind. Die übereinander liegenden Ringscheiben bilden dann im verschweißten Zustand die Röhrchen aus, die die entsprechende Kammer kreuzen. Das Kammervolumen wird von den Zwischenräumen zwischen den Stegen ausgebildet. Um eine verbesserte Durchströmung der Kammern mit den ihnen zugeordneten Fluiden, beispielsweise einem Gas oder einer Flüssigkeit, zu gewährleisten, besitzen die Stege eine geringere Materialstärke als die Scheiben selbst bzw. die die Röhrchen ausbildenden Ringscheiben. Die Materialstärke der Scheiben kann zwischen 0,2mm und 2mm liegen. Bevorzugt liegt die Materialstärke im Bereich zwischen 0,3mm und 1mm. Bezogen auf die Erstreckungsebene der einzelnen Scheiben besitzen die Stege eine Materialstärke, die geringer ist, als der Außendurchmesser der Ringscheiben. Die Ringscheiben können eine kreisrunde Umrisskontur besitzen. Die Umrisskontur der Ringscheiben kann aber auch davon abweichen. Es sind Maßnahmen vorgesehen, damit die bevorzugt im Wesentlichen deckungsgleich übereinander liegenden Stege gasdurchlässig sind. Die Stege miteinander verbundener Scheiben bilden gasdurchlässige Wände aus. Dies kann durch die oben bereits beschriebene Querschnittsverminderung erreicht werden. Es ist aber auch möglich, Scheiben mit unterschiedlicher Steggestaltung übereinander anzuordnen. Bevorzugt besteht der erfindungsgemäße Gasverteiler aus einer Vielzahl von unterschiedlich gestalteten Scheiben, wie es beim Stand der Technik ebenfalls der Fall ist. Allerdings ist erfindungsgemäß vorgesehen, dass jede Axialzone des Gasverteilers aus einer Vielzahl von gleichgestalteten Scheiben ausgebildet ist, die zur Fertigung lediglich übereinandergelegt werden, wobei unterschiedlich gestaltete Scheiben einander abwechseln können. Der Innendurchmesser der Röhrchen, also der Strömungskanäle, kann 0,4mm bis 1mm betragen. Die Flächendichte der Röhrchen bzw. die Flächendichte der Gasaustrittsöffnungen kann zwischen 10 und 20 pro cm² betragen. Mit dem darüber hinaus beanspruchten Verfahren ist die Fertigung eines Gasverteilers mit einem Durchmesser von mindestens 180mm möglich. Der Durchmesser kann auch mindestens 380mm bzw. mindestens 500mm betragen. Es ist sogar möglich, Gasverteiler mit Durchmessern von mehr als 700mm zu fertigen. Bevorzugt weist der Gasverteiler insgesamt zwei Gasvolumina auf. Eines dieser Gasvolumina kann von einem massiven Bauteil gefertigt werden. Das andere Gasvolumen kann Teil der diffusionsverschweißten Plattenstruktur sein. Die diffusionsverschweißte Plattenstruktur kann darüber hinaus auch die oben erwähnte Kühlkammer aufweisen, die von Röhrchen gekreuzt ist, die beide Gasvolumina getrennt voneinander mit den Gasaustrittsöffnungen des Bodens des Gasverteilers verbinden. In einer weiteren Ausgestaltung der Erfindung ist vorgesehen, dass sich im Bereich einer Kammer Platten abwechseln, bei denen die Ringscheiben in Stegmitte sich kreuzender Stege und bei denen die Ringscheiben auf den Kreuzungspunkten sich kreuzender Stege liegen.

Die Erfindung betrifft darüber hinaus ein Verfahren zur Fertigung eines derartigen Gasverteilers gemäß Anspruch 12. Das Fertigungsverfahren betrifft die Plattenstruktur des Gasverteilers, die von einer Vielzahl strukturierter Scheiben aus Metall, bevorzugt Edelstahl gebildet ist. Diese werden jeweils von Blechen gebildet. Die Bleche werden zunächst auf ihre äußere Gestalt geschnitten oder gestanzt. Sodann werden die Scheiben strukturiert. Soweit die Scheiben zwischen einzelnen Kammern angeordnet sind, besitzen sie lediglich Löcher. Die Scheiben, die eine Kammer ausbilden, besitzen eine Stegstruktur, wobei die Stege die Ringscheiben miteinander verbinden. Diese Stegstruktur kann durch ein Ätzverfahren gefertigt werden. Hierzu werden die auf Kontur geschnittenen Bleche zunächst fotolithographisch maskiert. Dabei wird zunächst großflächig ein fotosensitiver Fotolack auf die Breitseitenfläche der Platte aufgebracht. Nach einem Belichtungsschritt werden die nicht belichteten oder belichteten Zonen der Fotolackschicht wieder entfernt. Danach werden die vom Fotolack befreiten Zonen geätzt. Bevorzugt wird ein anisotroper Ätzprozess verwendet. In einem zweiten Ätzprozess, bei dem lediglich die Ringscheibenflächen und der Rand maskiert sind, kann die Materialstärke der Stege vermindert werden. Die so strukturierten Platten werden derart übereinander gelegt, dass sich die Ringscheiben zu Röhrchen ergänzen und die Kammern von Breitseitenflächen lediglich Löcher aufweisen. Schließlich wird der Plattenstapel in einem Ofen zusammengepresst und auf eine Temperatur gebracht, die etwas unterhalb der Schmelztemperatur des Metalls, insbesondere Edelstahl liegt. Der Plattenstapel wird solange diesem Druck und dieser Temperatur ausgesetzt, bis sich die aufeinander liegenden Breitflächen innig miteinander verbunden haben. Um die Identifikation der einzelnen Platten zu erleichtern, besitzt jede Platte in Form eines Randüberstandes einen Kennzeichnungszipfel, auf dem eine Kennzeichnung angebracht ist. Die Platten, die im wesentlichen einen kreisrunden Grundriss besitzen, können darüber hinaus von ihrem Rand abragende Justierlaschen aufweisen, die Justieröffnungen aufweisen. Eine Justiervorrichtung kann eine Vielzahl von Justierzapfen aufweisen, über die die Justierlaschen derart gelegt werden können, dass die Justierzapfen durch die Justieröffnungen ragen. Hierdurch ist ein passgenaues Aufeinanderlegen der strukturierten Scheiben möglich.

Ein Ausführungsbeispiel der Erfindung wird nachfolgend anhand beigefügter Zeichnungen erläutert. Es zeigen:
- Fig.1: auf dem Kopf stehend einen Gasverteiler in perspektivischer Darstellung;
- Fig. 2: einen Schnitt gemäß der Linie II - II in Fig.1;
- Fig. 2a: einen vergrößerten Ausschnitt aus Fig. 2, in dem die Zonen A, B, C, D, E des Gasverteilers dargestellt sind;
- Fig. 3: eine Draufsicht auf eine, die Zone A bildende Scheibe 3;
- Fig. 4: eine Draufsicht auf eine erste, die Zone B bildende Scheibe 4;
- Fig. 4a: einen vergrößerten Ausschnitt aus der Gitterstruktur der Scheibe 4;
- Fig. 4b: einen Schnitt gemäß der Linie IVb - IVb in Fig. 4a;
- Fig. 5: die Draufsicht auf eine zweite, die Zone B bildende Scheibe 4';
- Fig. 5a: einen vergrößerten Ausschnitt aus der Gitterstruktur der Scheibe gemäß Fig. 5;
- Fig. 6: eine Draufsicht auf eine Scheibe 5 der Zonen C, E;
- Fig. 7: die Draufsicht auf eine Scheibe 6 der Zone D;
- Fig. 7a: einen vergrößerten Ausschnitt der Gitterstruktur der in Fig. 7 dargestellten Scheibe 6 und
- Fig. 8: die Draufsicht auf ein durch Aufeinanderlegen der Scheiben 3, 4, 5, 6 gebildetes Scheibenpaket, welches mittels Justierzapfen 24 fixiert und justiert ist in Richtung auf den Boden 2'.

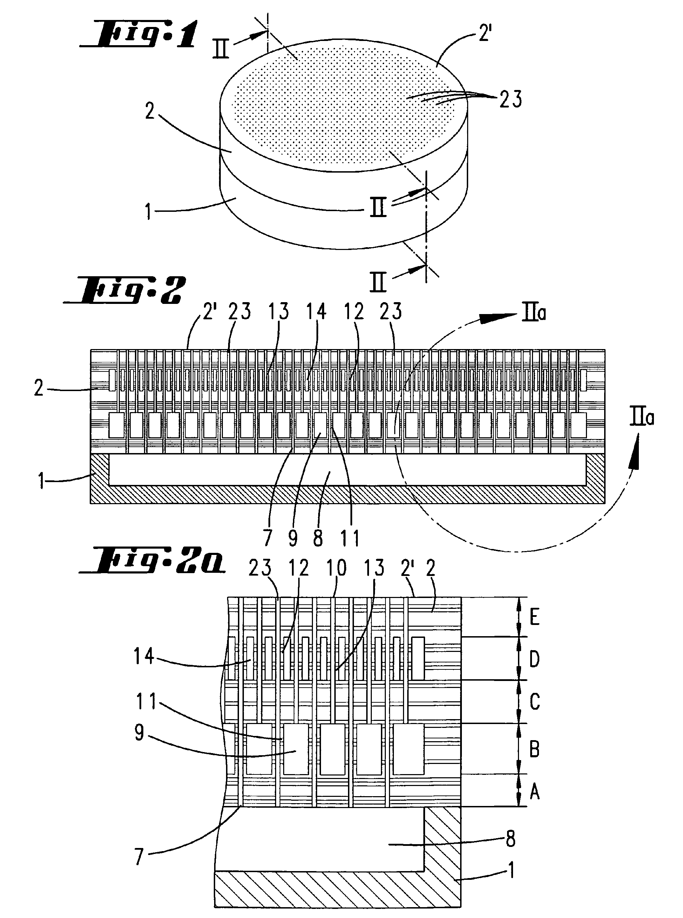

Das Ausführungsbeispiel betrifft einen Gasverteiler für einen CVD-Reaktor. Die Verwendung eines derartigen Gasverteilers wird insbesondere in der EP 0 687 749 A1 beschrieben. Der Gasverteiler ist Teil eines CVD-Reaktors und befindet sich vertikal oberhalb eines Suszeptors zur Aufnahme von zu beschichtenden Substraten. Die Substrate liegen auf einer Horizontalfläche des Suszeptors auf. Oberhalb des Suszeptors befindet sich die sogenannte Prozesskammer, in die von der Unterseite 2' des Gasverteilers 1, 2 die Prozessgase eingeleitet werden. Hierzu besitzt der in den Figuren 1 und 2 auf dem Kopf stehend dargestellte Gasverteiler 1, 2 nach unten weisende, dem Boden 2' des Gasverteilers 1, 2 zugeordnete Austrittsöffnungen 23, aus denen ein Prozessgas oder mehrere voneinander verschiedene Prozessgase austreten können. Die Prozessgase enthalten Bestandteile, die eine auf dem Substrat abzuscheidende Schicht ausbilden. Die Prozessgase können dabei Aerosole enthalten, die auf den Substraten lediglich kondensieren. In diesem Fall ist der Suszeptor gekühlt. Die Prozessgase können aber auch Reaktionsgase beinhalten, die sich in einer geheizten Prozesskammer zerlegen, wobei die Zerlegungsprodukte dann schichtbildend auf dem Substrat aufwachsen. Alternativ dazu kann die Bodenfläche des Gasverteilers aber auch mittels eines eine Kühlkammer 14 durchströmenden Kühlmittels gekühlt werden. Wird bei dieser Konfiguration der ein oder mehrere Substrate tragende Suszeptor geheizt, so können die aus den Austrittsöffnungen heraustretenden Reaktionsgase nahezu unzerlegt bis in den Bereich der Oberfläche strömen oder diffundieren, um sich dort beim Oberflächenkontakt pyrolytisch zu zerlegen. Auch hier baut sich die Schicht auf den Substraten aus den Zerlegungsprodukten der Reaktionsgase auf. Die Prozesskammer ist in einem Reaktorgehäuse gekapselt, welches gas- und druckdicht gegen die Umgebung verschlossen ist. Die Reaktionsgase bzw. die Aerosole werden von außerhalb des Reaktors mittels Zuleitungen dem Gasverteiler zugeleitet. Werden verschiedene Prozessgase bzw. Aerosole verwendet, so kann jedem Prozessgas bzw. jedem Aerosol eine eigene Kammer in Form eines Gasvolumens 8, 9 zugeordnet sein.

Die Figur 2 zeigt im Querschnitt, auf dem Kopf stehend den Aufbau eines derartigen Gasverteilers. Der Gasverteiler besteht aus einem von einer optionalen, massiven Platte gebildeten Oberteil 1, welches in Form einer Ausnehmung ein erstes Gasvolumen 8 ausbildet. Das Gasvolumen 8 ist von der Breitseite eines Gasverteilerunterteils 2 verschlossen. Diese Breitseite des Gasverteilerunterteils ist mittels einer Vielzahl, beispielsweise 10.000 bis 20.000 Gasaustrittskanälen 7 mit der Unterseite 2' des Gasverteilers verbunden. Dort münden die Gasaustrittskanäle 7 in Austrittsöffnungen 23.

Der Gasverteiler 2 weist darüber hinaus ein zweites Gasvolumen 9 auf, welches mit separaten Zuleitungen gespeist wird. Dieses Gasvolumen 9 wird von Röhrchen 11 gekreuzt, die den Gasaustrittskanal 7 des oberen Gasvolumens 8 ausbilden.

Das Gasverteilerunterteil 2 besitzt darüber hinaus eine dem Boden 2' benachbarte Kühlkammer 14, die ebenfalls von Röhrchen 12,13 gekreuzt wird, wobei die Röhrchen 12,13 zum einen den Gasaustrittskanal 7 des Volumens 8 und zum anderen den Gasaustrittskanal 10 des Gasvolumens 9 ausbilden.

Das Gasverteilerunterteil 2 wird von einer Vielzahl von etwa 1mm starken, strukturierten Scheiben 3, 4, 5, 6 gebildet, die zunächst in entsprechender Weise strukturiert, dann aufeinandergelegt und schließlich unter Druck und Temperatur miteinander diffusionsverschweißt werden.

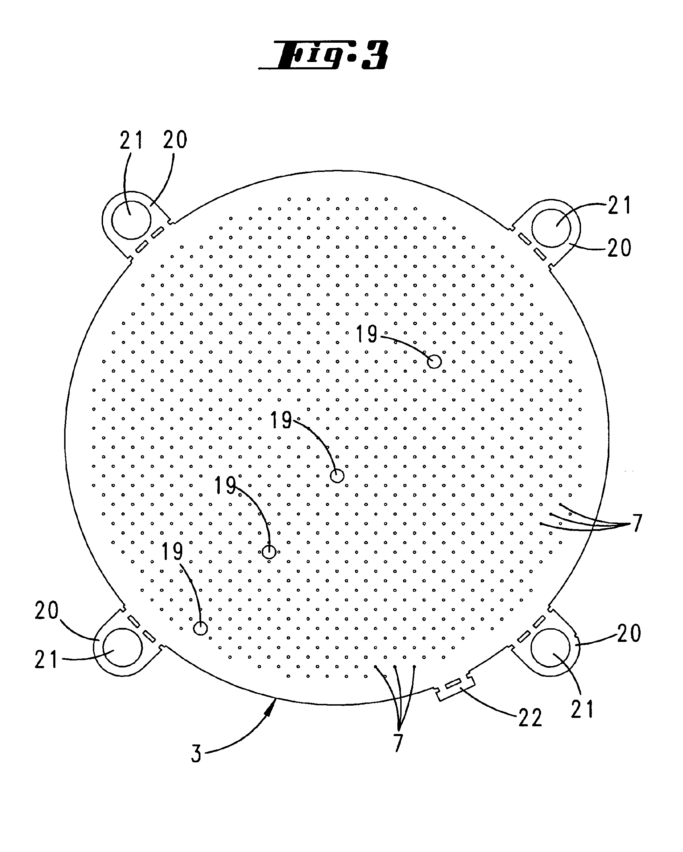

Insgesamt besteht die in den Figuren 2 und 2a dargestellte Scheibenstruktur aus fünf verschieden strukturierten Scheiben 3, 4, 4', 5 und 6. Mit diesen Scheiben werden die in der Figur 2 dargestellten Zonen A, B, C, D, E gebildet. Die Zone A wird von einer Vielzahl von Scheiben 3 ausgebildet, die in der Figur 3 dargestellt sind. Es handelt sich dabei um eine kreisrunde Scheibe, die eine Vielzahl von gleichmäßig angeordneten Öffnungen 7 besitzt, die einen Durchmesser zwischen 0,4mm und 1mm besitzen. Die Flächendichte dieser Gasaustrittskanäle 7 kann zwischen 10 und 20 pro cm² betragen. Die Öffnungen können gebohrt werden. Bevorzugt werden die Öffnungen aber geätzt. Hierzu wird die gesamte Breitseitenfläche der Scheibe 3 mit einem Fotolack überzogen. Es erfolgt eine Belichtung mittels einer Maske, die der Struktur der Öffnungen entspricht. Anschließend wird der nicht belichtete oder belichtete Fotolack entfernt und werden die Öffnungen geätzt.

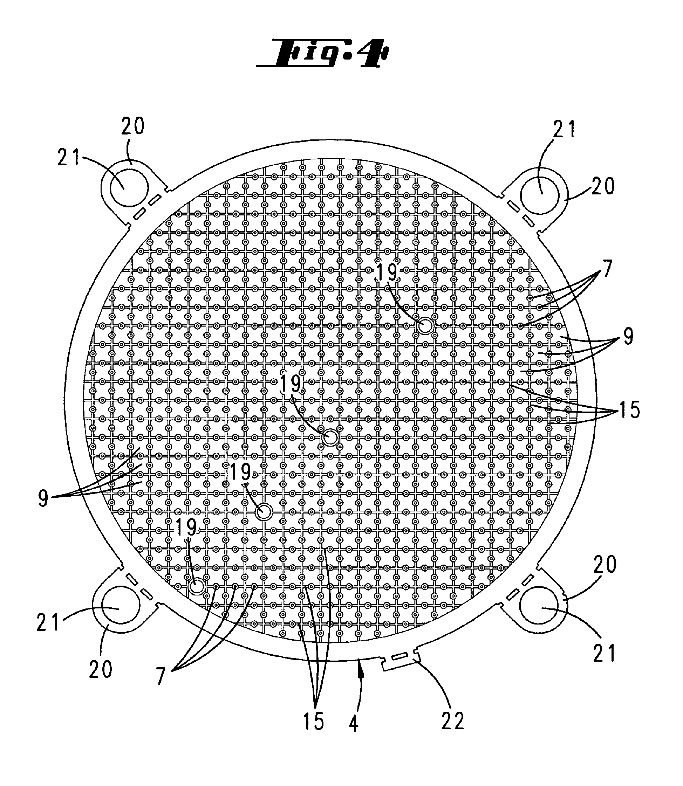

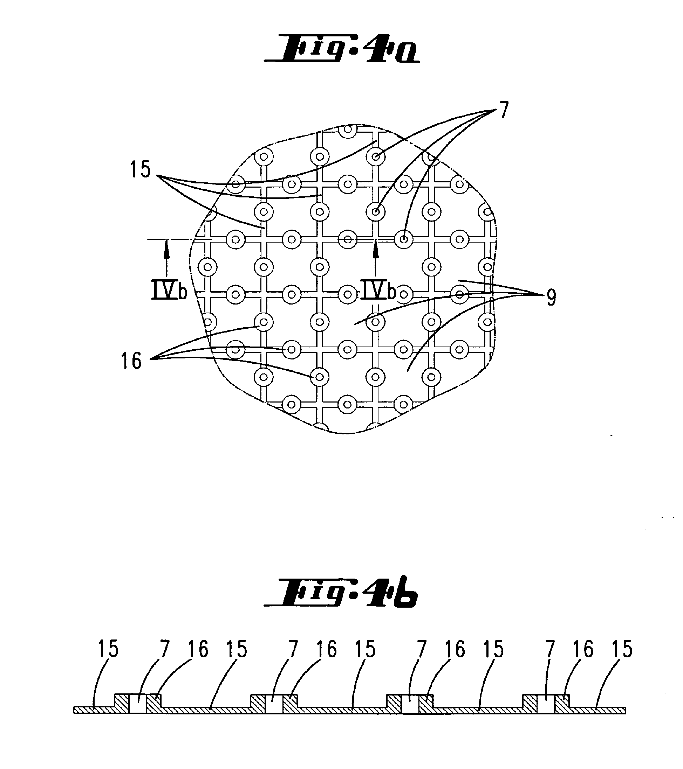

Die Figuren 4, 4a zeigen die Draufsicht auf eine Scheibe 4 der Zone B. Die Scheibe weist einen massiven, durchgängigen Rand auf und innerhalb des Randes mit, gemäß der Erfindung. Stegen 15 miteinander verbundene Ringscheiben 16. Die Ringscheiben 16 besitzen eine zentrale Öffnung, die dem Gasaustrittskanal 7 zugeordnet sind. Bei der in den Figuren 4, 4a dargestellten, der Zone B zugehörigen Scheibe 4 befinden sich die Ringscheiben 16 in Stegmitte, wobei sich die Stege 15 kreuzen. Aus der Figur 4b ist zu ersehen, dass die Stege 15 eine gegenüber den Ringscheiben 16 verminderte Materialstärke besitzen.

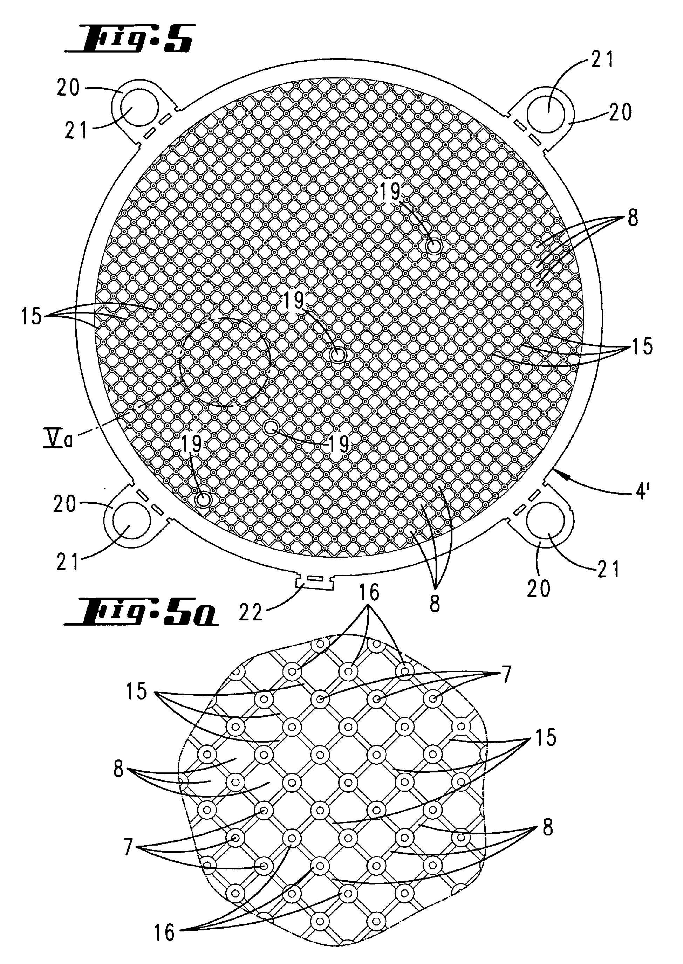

Die Figuren 5, 5b zeigen die Draufsicht einer Variante einer Scheibe 4' der Zone B, die abwechselnd mit einer Scheibe 4 angeordnet werden kann. Bei dieser Variante liegen die Ringscheiben 16 auf den Kreuzungspunkten der sich kreuzenden Stege 15. Die Stege 15 der Scheibe 4' verlaufen diagonal zu den Stegen der Scheibe 4. Auch hier besitzen die Stege 15 eine verminderte Materialstärke.

Die Scheiben 4, 4' können ebenso wie die Scheibe 3 oder die weiter unten noch zu erläuternden Scheiben 5 und 6 durch Ätzen strukturiert werden, wobei auch hier die Steg-Ringscheibenstruktur fotolithographisch erzeugt wird und anschließend der nicht maskierte Bereich der Scheiben anisotrop weggeätzt wird.

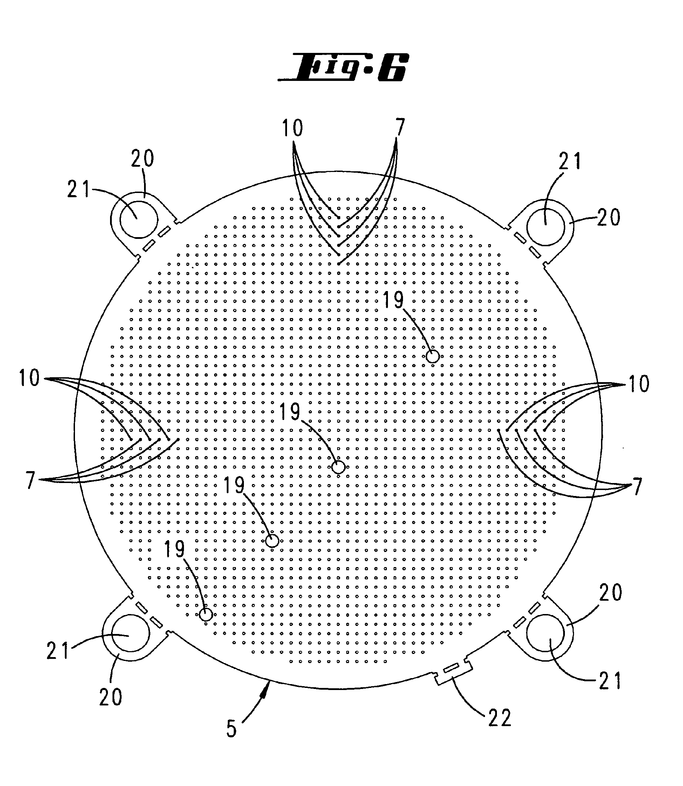

Die Figur 6 zeigt eine Scheibe 5, mit der durch Aufeinanderlage mehrerer Scheiben die Zonen C und E gebildet werden können. Die Scheibe unterscheidet sich von der Scheibe 3 im wesentlichen nur durch eine doppelt so hohe Anzahl der Öffnungen. Hier liegen die dem Gasvolumen 8 zugeordneten Gasaustrittskanäle 7 und die dem Gasvolumen 9 zugeordneten Gasaustrittskanäle 10 nebeneinander.

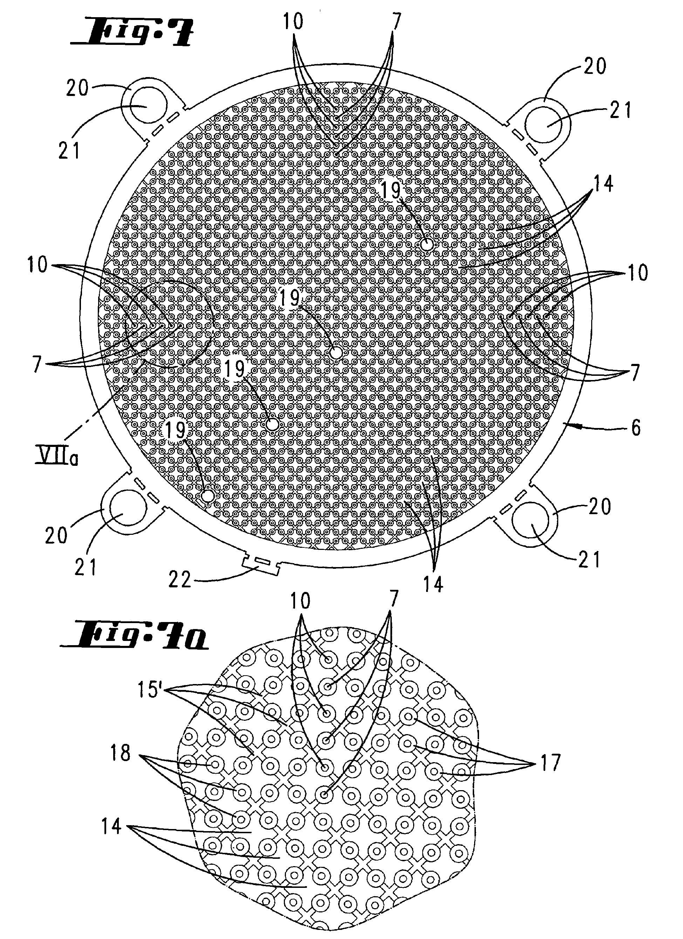

Die Figuren 7, 7a zeigen eine der Zone D zugeordnete Scheibe 5, die einen ähnlichen Aufbau besitzt wie die bereits oben erörterten Scheiben 4, 4'. Hier ist die Anzahl der Ringscheiben 17, 18 allerdings doppelt so groß, da sie die Röhrchen der beiden Austrittskanäle 7,10 ausbildet. Hier liegen die Ringscheiben 17 der Gasaustrittskanäle 10 an den Kreuzungspunkten von sich kreuzenden Stegen 15' und die Ringscheiben 18, die die Gasaustrittskanäle 7 ausbilden, stegmittig der Stege 15'. Auch hier besitzen die Stege 15' eine verminderte Materialstärke.

Die Stegzwischenzonen zwischen den Stegen 15,15' bilden die Volumina aus, wobei der Zwischenraum zwischen den Stegen 15 ein Gasvolumen 9 ausbildet und der Zwischenraum zwischen den Stegen 15' eine Kühlwasserkammer 14. Wegen der verminderten Materialstärke der Stege 15,15' sind die einzelnen Stegzwischenräume miteinander strömungsverbunden.

Die Scheiben 3, 4, 4', 5 und 6 bilden jeweils von ihrem Rand abragende, in gleichmäßiger Winkelverteilung angeordnete Zentrierlaschen 20 aus. Diese Zentrierlaschen 20 sind mit perforierten Stegen mit dem Rand der Scheibe 3, 4, 4', 5, 6 verbunden.

Es ist eine Justiervorrichtung vorgesehen, die vier Justierzapfen 24 ausbildet, die parallel zueinander verlaufen und deren Durchmesser dem Innendurchmesser der Justieröffnungen 21 entspricht.

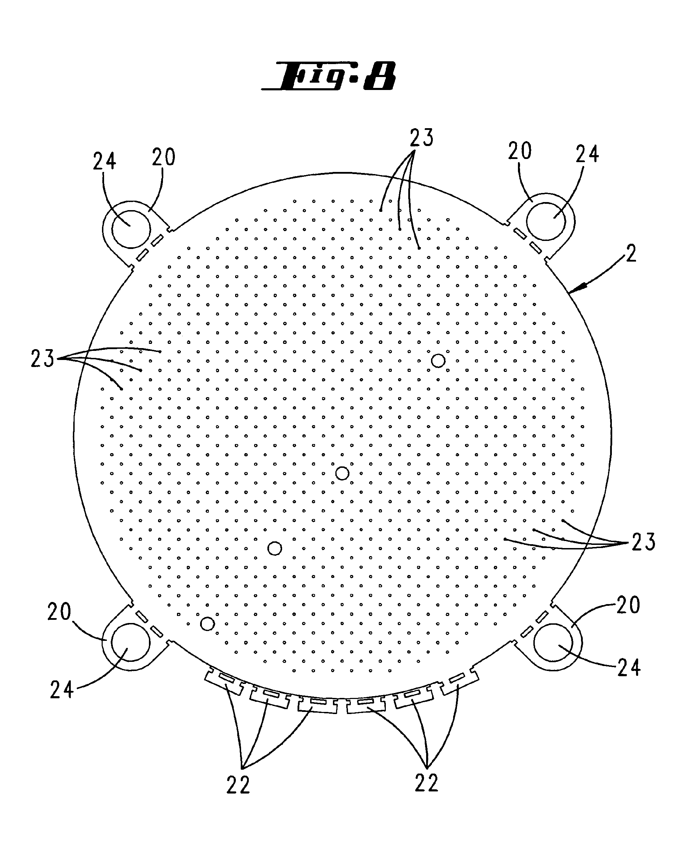

Die Figur 8 zeigt einen Stapel aufeinander gelegter Scheiben, wobei die jeweiligen Justierlaschen 20 über die Justierzapfen 24 gestülpt sind.

Jede der den Zonen A, B, C, D und E zugehörige Scheibe 3, 4, 4', 5 und 6 besitzt an ihrem Rand darüber hinaus einen Kennzeichnungszipfel 22, auf dem eine Kennzeichnung steht, damit die Platten nicht verwechselt werden können. Zur Vermeidung von Verwechslungen sind die Kennzeichnungszipfel 22 der den unterschiedlichen Zonen, A, B, C, D, E zugeordneten Scheiben auch an unterschiedlichen Winkelpositionen angebracht.

Wenn die Platten zu dem in der Figur 8 dargestellten Stapel übereinander gelegt worden sind, berühren sich die Breitseitenflächen benachbarter Platten. Dieser Plattenstapel wird dann in einem Ofen mit Druck beaufschlagt. Dabei werden die Breitseitenflächen der Scheiben 3, 4, 4', 5, 6 mit etwa 1,5 MPa gegeneinander gepresst. Gleichzeitig wird der Scheibenstapel auf eine Temperatur aufgeheizt, die etwas unterhalb der Schmelztemperatur des Metalls, aus dem die Scheiben gefertigt sind, liegt. Eine bevorzugte Temperatur beträgt 1100°C. Mit diesen Prozessparametern wird der Plattenstapel im Vakuum oder in einer Schutzgasatmosphäre solange behandelt, bis sich die aufeinanderliegenden Breitseitenabschnitte der einzelnen Scheiben 3, 4, 4', 5, 6 innig miteinander verbunden haben, so dass ein massiver strukturierter Festkörper entstanden ist, der das Gasverteilerunterteil 2 ausbildet. Die Behandlungsdauer kann etwa 4 Stunden betragen.

In einer Variante der Erfindung ist vorgesehen, dass die Behandlungstemperatur während der Behandlung um 50° erhöht wird. Die Behandlungstemperatur kann in einem Fenster zwischen 1000 und 1200°C liegen.

Die Verbindung des Gasverteilerunterteils 2 mit dem Gasverteileroberteil 1 kann durch herkömmliches Schweißen erfolgen.

In einer nicht dargestellten Variante kann vorgesehen sein, dass das Gasverteileroberteil 1 auch von einem Teil einer Wandung eines Reaktorgehäuses gebildet ist, wie es beispielsweise die Figur 2 der EP 0 687 749 A1 zeigt. Es ist darüber hinaus auch möglich, den erfindungsgemäßen Gasverteiler ohne ein massives Oberteil 1 herzustellen.

## Patentansprüche

1. Gasverteiler (1, 2) für einen CVD-Reaktor mit zwei oder mehreren Kammern (8, 9,14), in die jeweils Zuleitungen münden, wobei zumindest eine der Kammern (8, 9) ein Gasvolumen ausbildet und mittels einer Vielzahl von zumindest eine andere Kammer (9,14) kreuzenden Röhrchen (11, 12, 13) mit dem Boden (2') des Gasverteilers (1, 2) zugeordneten Gasaustrittsöffnungen (23) verbunden ist, wobei der Gasverteiler (1, 2) von einer Vielzahl von aufeinanderliegenden fest miteinander verbundenen Elementen besteht, **dadurch gekennzeichnet, dass** die Elemente zumindest im Bereich der Röhrchen (11,12,13) aus einer Vielzahl strukturierter, aufeinander liegender Scheiben (3, 4, 4', 5, 6) aus Metall besteht, die fest miteinander verbunden sind und insbesondere durch Druck und Temperatur miteinander diffusionsverschweißt sind, wobei die Röhrchen (11,12,13) aus einer Vielzahl von insbesondere deckungsgleich übereinander liegenden Ringscheiben (16, 17,18) gebildet sind, die über Stege (15,15') mit dem Rand der Kammern (9,14) oder miteinander verbunden sind.

2. Gasverteiler nach Anspruch 1, **dadurch gekennzeichnet, dass** eine Vielzahl der Scheiben (4, 4', 6) aus Edelstahl bestehen.

3. Gasverteiler nach einem der vorangehenden Ansprüche, **gekennzeichnet durch** Stege (15, 15') einer geringeren Materialstärke als die Scheiben (3, 4, 4', 5, 6).

4. Gasverteiler nach einem der vorangehenden Ansprüche, **dadurch gekennzeichnet, dass** die Stege (15, 15') miteinander verbundener Scheiben (4, 4', 6) gasdurchlässige Wände ausbilden.

5. Gasverteiler nach einem der vorangehenden Ansprüche, **gekennzeichnet durch** eine Materialstärke der Scheiben (3, 4, 4', 5, 6) von 0,3 mm bis 1 mm.

6. Gasverteiler nach einem der vorangehenden Ansprüche, **gekennzeichnet durch** einen Innendurchmesser der Röhrchen (11,12,13) von 0,4 mm bis 1 mm.

7. Gasverteiler nach einem der vorangehenden Ansprüche, **gekennzeichnet durch** eine Flächendichte der Röhrchen (11, 12, 13) von 10 bis 20 pro cm² oder größer als 20 pro cm².

8. Gasverteiler nach einem der vorangehenden Ansprüche, **gekennzeichnet durch** mindestens zwei Gasvolumina (8, 9), die jeweils mit Röhrchen (12, 13), die eine Kühlkammer (14) durchdringen, mit dem Boden (2') verbunden sind.

9. Gasverteiler nach einem der vorangehenden Ansprüche
, **dadurch gekennzeichnet, dass** sich eine Kammer (9) ausbildende Platten (4,4') einander abwechseln, bei denen die Ringscheiben (16) in Stegmitte sich kreuzender Stege (15) und bei denen die Ringscheiben (16) auf den Kreuzungspunkten sich kreuzender Stege (15) liegen.

10. Gasverteiler nach einem der vorangehenden Ansprüche, **dadurch gekennzeichnet, dass** die Scheiben (3, 4, 4', 5, 6) entfernbare seitlich abragende Justierlaschen (20) aufweisen, die jeweils eine Justieröffnung (21) aufweisen, wobei die Justieröffnungen (21) beim Übereinanderlegen der Scheiben (3, 4, 4', 5, 6) über Justierzapfen (24) einer Montagehilfsvorrichtung gelegt werden.

11. Gasverteiler nach einem der vorangehenden Ansprüche, **gekennzeichnet durch** den Scheiben (3, 4, 4', 5, 6) zugeordnete Kennzeichnungszipfel (22), die nach dem Diffusionsverschweißen der Scheiben (3, 4, 4', 5, 6) entfernbar sind.

12. Verfahren zur Fertigung eines Gasverteilers insbesondere gemäß einem oder mehreren der vorangehenden Ansprüche, **gekennzeichnet durch**
- Fertigen von strukturierten Scheiben (3, 4, 4', 5, 6) aus Metall, insbesondere Edelmetall, wobei eine Vielzahl der Scheiben (4, 4', 6) über Stege (15, 15') miteinander verbundene Ringscheiben (16,17,18) ausbilden und eine weitere Vielzahl von Scheiben (3, 5) zu den Öffnungen der Ringscheiben (16, 17, 18) korrespondierende Löcher (7, 10) ausbilden;
- Übereinanderlegen der Scheiben (3, 4, 4', 5, 6) derart, dass sich die Ringscheiben (16,17,18) zu Röhrchen (11,12,13) ergänzen, die zumindest eine ein Gasvolumen (8, 9) bildende Kammer mit dem Boden (2') des Gasverteilers (2) zugeordneten Gasaustrittsöffnungen (23) verbinden und die eine andere Kammer (9,14) kreuzen, wobei der Boden und die Decke jeweils einer Kammer (9,14), die von aufeinander liegenden Scheiben (4, 6) gebildet ist, von der Breitfläche lediglich Bohrungen aufweisender Scheiben gebildet sind;
- Diffusionsverschweißen der aufeinander liegenden Scheiben (3, 4, 4', 5, 6) **durch** Aufbringen von Druck und Temperatur;

13. Verfahren nach Anspruch 12, **dadurch gekennzeichnet, dass** die Scheiben (3, 4, 4', 5, 6) aus Blech gefertigt werden, auf denen eine der Kontur der Stege (15, 15') und der Ringscheiben (16,17,18) entsprechende Maske aufgebracht wird und anschließend die Konturzwischenräume freigeätzt werden.

14. Verfahren nach Anspruch 12 oder 13, **dadurch gekennzeichnet, dass** die Materialstärke der Platte im Bereich zumindest einiger der Stege (15, 15') durch Ätzen vermindert wird.

15. Verfahren nach einem der Ansprüche 12 bis 14, **dadurch gekennzeichnet, dass** die Scheiben (3, 4, 4', 5, 6) seitlich abragende Justierlaschen (20) mit Justieröffnungen (21) aufweisen, die in einem vormontierten Zustand der aufeinander liegenden Scheiben (3, 4, 4', 5, 6) von Justierzapfen (24) einer Justiervorrichtung durchdrungen sind.

## Claims

1. Gas distributor (1, 2) for a CVD reactor with two or more chambers (8, 9, 14), into each of which supply lines open out, at least one of the chambers (8, 9) defining a gas volume and being connected to gas outlet openings (23) associated with the bottom (2') of the gas distributor (1, 2) by means of a multiplicity of small tubes (11, 12, 13) crossing at least one other chamber (9, 14), the gas distributor (1, 2) consisting of a multiplicity of elements fixedly connected to one another and lying one above the other, **characterized in that**, at least in the region of the small tubes (11, 12, 13), the elements consist of a multiplicity of structured disks (3, 4, 4', 5, 6) of metal, lying one above the other, which are fixedly connected to one another and, in particular, are diffusion-welded to one another by pressure and temperature, the small tubes (11, 12, 13) being formed by a multiplicity of annular disks (16, 17, 18), in particular lying congruently one above the other, the disks being connected to the periphery of the chambers (9, 14) or to one another by way of webs (15, 15').

2. Gas distributor according to Claim 1, **characterized in that** a multiplicity of the disks (4, 4', 6) consist of stainless steel.

3. Gas distributor according to any of the preceding claims, **characterized by** webs (15, 15') having a smaller material thickness than the disks (3, 4, 4', 5, 6).

4. Gas distributor according to any of the preceding claims, **characterized in that** the webs (15, 15') of disks (4, 4', 6) connected to one another define gas-permeable walls.

5. Gas distributor according to any of the preceding claims, **characterized by** a material thickness of the disks (3, 4, 4', 5, 6) of from 0.3 mm to 1 mm.

6. Gas distributor according to any of the preceding claims, **characterized by** an inside diameter of the small tubes (11, 12, 13) of from 0.4 mm to 1 mm.

7. Gas distributor according to any of the preceding claims, **characterized by** a surface density of the small tubes (11, 12, 13) of from 10 to 20 per cm² or of greater than 20 per cm².

8. Gas distributor according to any of the preceding claims, **characterized by** at least two gas volumes (8, 9), which are respectively connected to the bottom (2') by small tubes (12, 13), which pass through a cooling chamber (14).

9. Gas distributor according to any of the preceding claims, **characterized in that** plates (4, 4') forming a chamber (9) alternate with one another such that plates on which the annular disks (16) lie at the web midpoint of crossing webs (15) alternate with plates on which the annular disks (16) lie on the crossing points of crossing webs (15).

10. Gas distributor according to any of the preceding claims, **characterized in that** the disks (3, 4, 4', 5, 6) have removable laterally protruding alignment lugs (20), each of which has an alignment opening (21), the alignment openings (21) being placed over alignment pins (24) of an assembly aid when the disks (3, 4, 4', 5, 6) are placed one above the other.

11. Gas distributor according to any of the preceding claims, **characterized by** identification tags (22) that are associated with the disks (3, 4, 4', 5, 6) and can be removed after the diffusion welding of the disks (3, 4, 4', 5, 6).

12. Method for producing a gas distributor, in particular according to one or more of the preceding claims, **characterized by**
- producing structured disks (3, 4, 4', 5, 6) of metal, in particular stainless steel, a multiplicity of disks (4, 4', 6) providing annular disks (16, 17, 18) that are connected to one another by way of webs (15, 15') and a further multiplicity of disks (3, 5) defining holes (7, 10) corresponding to the openings in the annular disks (16, 17, 18);
- placing the disks (3, 4, 4', 5, 6) one above the other in such a way that the annular disks (16, 17, 18) make up small tubes (10, 12, 13), which connect at least one chamber forming a gas volume (8, 9) to gas outlet openings (23) associated with the bottom (2') of the gas distributor (2) and cross another chamber (9, 14), the floor and ceiling of a chamber (9, 14) that is formed by disks (4, 6) lying one above the other respectively being formed by the broad face of disks merely having bores;
- diffusion-welding the disks (3, 4, 4', 5, 6) that lie one above the other by applying pressure and temperature.

13. Method according to Claim 12, **characterized in that** the disks (3, 4, 4', 5, 6) are produced from sheet metal, to which a mask corresponding to the layout of the webs (15, 15') and the annular disks (16, 17, 18) is applied and subsequently the interspaces in the web layout are etched free.

14. Method according to Claim 12 or 13, **characterized in that** the material thickness of the plate is reduced in the region of at least some of the webs (15, 15') by etching.

15. Method according to any of Claims 12 to 14, **characterized in that** the disks (3, 4, 4', 5, 6) have laterally protruding alignment lugs (20) with alignment openings (21), which, in a pre-mounted state of the disks (3, 4, 4', 5, 6) lying one above the other, are passed through by alignment pins (24) of an alignment device.

## Revendications

1. Distributeur de gaz (1, 2) pour réacteur CVD, ledit distributeur de gaz comportant deux chambres (8, 9, 14) ou plus dans chacune desquelles débouche une conduite d'amenée, au moins une des chambres (8, 9) formant un volume de gaz et étant reliée à des ouvertures de sortie de gaz (23), associées au fond (2') du distributeur de gaz (1, 2), au moyen d'un grand nombre de tubes capillaires (11, 12, 13) croisant au moins une autre chambre (9, 14), le distributeur de gaz (1, 2) étant constitué d'un grand nombre d'éléments reliés de façon fixe entre eux étant disposés l'un sur l'autre, **caractérisé en ce que** les éléments, au moins dans la région des tubes capillaires (11, 12, 13), sont constitués d'un grand nombre de disques métalliques (3, 4, 4', 5, 6), dotés de structures et disposés l'un sur l'autre, qui sont reliés de façon fixe entre eux et qui sont soudés entre eux par diffusion notamment par apport de pression et de température, les tubes capillaires (11, 12, 13) étant formés par un grand nombre de disques annulaires (16, 17, 18) qui sont superposés notamment de façon coïncider et qui sont reliés entre eux ou au bord des chambres (9, 14) par le biais de nervures (15, 15 ").

2. Distributeur de gaz selon la revendication 1, **caractérisé en ce qu'**un grand nombre des disques (4, 4', 6) sont en acier fin.

3. Distributeur de gaz selon l'une des revendications précédentes, caractérisé en ce par des nervures (15, 15') dont l'épaisseur de matière est inférieure à celle des disques (3, 4, 4', 5, 6).

4. Distributeur de gaz selon l'une des revendications précédentes, **caractérisé en ce que** les nervures (15, 15') de disques (4, 4', 6) reliés entre eux forment des parois étanches au gaz.

5. Distributeur de gaz selon l'une des revendications précédentes, **caractérisé en ce que** l'épaisseur de matière des disques (3, 4, 4', 5, 6) est de 0, 3 mm à 1 mm.

6. Distributeur de gaz selon l'une des revendications précédentes, **caractérisé en ce que** le diamètre intérieur des tubes capillaires (11, 12, 13) est de 0,4 mm à 1 mm.

7. Distributeur de gaz selon l'une des revendications précédentes, **caractérisé en ce qu'**une densité superficielle des tubes capillaires (11, 12, 13) est de 10 à 20 par cm² ou supérieure à 20 par cm².

8. Distributeur de gaz selon l'une des revendications précédentes, **caractérisé par** au moins deux volumes de gaz (8, 9) qui sont chacun reliés au fond (2) par des tubes capillaires (12, 13) qui traversent une chambre de refroidissement (14).

9. Distributeur de gaz selon l'une des revendications précédentes, **caractérisé en ce que** des plaques (4, 4') formant une chambre (9) alternent l'une avec l'autre, dans lesquelles les disques annulaires (16) sont disposés au milieu de nervures (15) qui se croisent et dans lesquels les disques annulaires (16) sont disposés sur les points d'intersection des nervures (15) qui se croisent.

10. Distributeur de gaz selon l'une des revendications précédentes, **caractérisé en ce que** les disques (3, 4, 4', 5, 6) comportent des pattes d'ajustage (20) démontables qui font saillies latéralement et qui comportent chacune une ouverture d'ajustage (21), les ouvertures d'ajustage (21) étant placées sur des chevilles d'ajustage (24) d'un dispositif auxiliaire de montage lorsque les disques (3, 4, 4', 5, 6) sont superposés.

11. Distributeur de gaz selon l'une des revendications précédentes, **caractérisé par** des détrompeurs (22) qui sont associés aux disques (3, 4, 4', 5, 6) et qui peuvent être retirés après avoir soudé les disques (3, 4, 4', 5, 6) par diffusion.

12. Procédé de fabrication d'un distributeur de gaz, notamment selon une ou plusieurs des revendications précédentes, **caractérisé par**
- la réalisation de disques métalliques (3, 4, 4', 5, 6), notamment en métal fin, dotés de structures, un grand nombre des disques (4, 4', 6) formant des disques annulaires (16, 17, 18) reliés entre eux par des nervures (15, 15') et un autre grand nombre de disques (3, 5) formant des trous (7, 10) correspondant aux ouvertures des disques annulaires (16, 17, 18) ;
- la superposition des disques (3, 4, 4', 5, 6) de telle sorte que les disques annulaires (16, 17, 18) se complètent pour former des tubes capillaires (11, 12, 13) qui relient au moins une chambre formant un volume de gaz (8, 9) à des ouvertures de sortie de gaz (23) associées au fond (2') du distributeur de gaz (2) et qui croisent une autre chambre (9, 14), le fond et le couvercle d'une chambre (9, 14) respective, qui est formée par des disques (4, 6) placés l'un sur l'autre, étant formés par la grande surface uniquement de disques dotés de perçages;
- le soudage par diffusion des disques (3, 4, 4', 5, 6), disposés l'un sur l'autre, par apport de pression et de température.

13. Procédé selon la revendication 12, **caractérisé en ce que** les disques (3, 4, 4', 5, 6), sur lesquels est placé un masque correspondant au contour des nervures (15, 15') et des disques annulaires (16, 17, 18), sont fabriqués en tôle puis les espaces entre les contours sont attaqués chimiquement.

14. Procédé selon la revendication 12 ou 13, **caractérisé en ce que** l'épaisseur de matière de la plaque dans la région d'au moins certaines nervures (15, 15') est réduite par attaque chimique.

15. Procédé selon l'une des revendications 12 à 14, **caractérisé en ce que** les disques (3, 4, 4', 5, 6) comportent des pattes d'ajustage (20), saillant latéralement et dotées d'ouvertures d'ajustage (21), qui sont traversées par des chevilles d'ajustage (24) d'un dispositif d'ajustage lorsque les disques (3, 4, 4', 5, 6) disposés l'un sur l'autre sont préalablement montés.
